# EUROPEAN PATENT APPLICATION

(11) **EP 3 309 849 A1**
(43) Date of publication of application: **18.04.2018**
(21) Application number: 16194119.0
(22) Date of filing: 17.10.2016
(51) Int. Cl.: H01L 39/24

(54) **METHOD FOR DEPOSITING A HTS ON A TAPE, WITH A SOURCE RESERVOIR, A GUIDE STRUCTURE AND A TARGET RESERVOIR ROTATING ABOUT A COMMON AXIS**

(71) Applicant: Bruker HTS GmbH, 63450 Hanau (DE)
(72) Inventor: Usoskin, Alexander, 63456 Hanau (DE)
(74) Representative: Kohler Schmid Möbus Patentanwälte

(57) **Abstract**

A method for depositing a high temperature superconductor (=HTS) onto a tape (2), in particular by pulsed laser deposition (=PLD),
wherein the tape (2) is wound off a source reservoir (3), heated and transported through a deposition zone (21), and wound up at a target reservoir (5), wherein HTS material (32) is deposited onto the heated transported tape (2) in the deposition zone (21), and wherein the tape (2) is led through the deposition zone (21) by means of a guide structure (4), is characterized in that during deposition of the HTS material (32), the source reservoir (3), the guide structure (4) and the target reservoir (5) are rotated around a common rotation axis (9), such that parts of the tape (2) rotating along with the guide structure (4) repeatedly cross the deposition zone (21). The invention provides a method for depositing a HTS onto a tape, in particular by PLD, allowing a high quality of the deposited HTS material for long tape lengths.

## Description

The invention relates to a method for depositing a high temperature superconductor (=HTS) onto a tape, in particular by pulsed laser deposition (=PLD),
wherein the tape is wound off a source reservoir, heated and transported through a deposition zone, and wound up at a target reservoir,
wherein HTS material is deposited onto the heated transported tape in the deposition zone,
and wherein the tape is led through the deposition zone by means of a guide structure.

Such a method is known from US 2007/0148329 A1.

High temperature superconductors (HTS) are typically used in tape form, from which e.g. magnet coils can be wound. The tape comprises a substrate, typically of a thin metal such as stainless steel, coated with a layer of the HTS material; for this reason, such tapes are also referred to as coated conductors. In general, one or a plurality of buffer layers are arranged between the substrate surface and the HTS layer, and often one or a plurality of cover layers are arranged on top of the HTS layer.

A common method for depositing HTS material on a substrate is pulsed laser deposition (PLD). In this process, short laser pulses are shot onto a target of the HTS material to be deposited, generating a plasma of said material. Opposing the target there is the tape, onto which said material is then deposited. It should be noted that for a typical tape, each spot on the tape has to be subject to several deposition pulses, with each deposition pulse affecting only a tiny portion of a tape, so a very large number of deposition pulses is necessary.

It has been found that the quality of the deposited HTS material may be improved by heating the substrate, and further moving the tape relative to the target with a moderate speed. Moving the tape distributes the deposition pulse over some length of the tape. In order allow several deposition pulses on the same spot of the tape, each tape section has to be presented numerous times to the target.

EP 1 104 033 B1 describes a method for preparing a superconducting layer on a tape by means of pulsed laser deposition, wherein the tape is helically wound on a tube, with the tube being rotated about its axis and linearly moved along its axis during deposition.

This method allows to move the tape with respect to the target at a desired speed by setting the rotation speed of the tube, and thus allows a good superconductor material quality. However, the tape length is limited by the length of the tube onto which the tape is wound, and the required winding of tape on the tube beforehand is cumbersome.

US 2007/0148329 A1 describes a method and an apparatus for making a superconducting conductor, wherein a substrate tape is wound from a rotating feed reel, led via a guide structure through a MOCVD deposition chamber and a fed onto a rotating take-up reel. The guide structure leads the tape on a helical path using eight rod-like rollers.

With this method, the tape to be processed is stored on reels, so relatively long tape lengths are possible. However, for establishing a relative desired speed of the tape with respect to a deposition zone, the tape would have to be wound off and up and led through the guide structure accordingly during deposition, what puts considerable load and abrasion on the tape. In order to present the tape several times to the deposition zone, the tape would have to be translated back and forth, going along with further load and abrasion, deteriorating the overall quality of the coated conductor.

### Object of the invention

It is therefore the object of the invention to present a method for depositing a HTS onto a tape, in particular by PLD, allowing a high quality of the deposited HTS material for long tape lengths.

### Short description of the invention

This object is achieved, in accordance with the invention, by a method as mentioned in the beginning, characterized in that during deposition of the HTS material, the source reservoir, the guide structure and the target reservoir are rotated around a common rotation axis, such that parts of the tape rotating along with the guide structure repeatedly cross the deposition zone.

In accordance with the invention, a desired relative speed between the tape and a deposition zone, and in particular a deposition device or target providing material in the deposition zone, can be established by rotating the guide structure that leads the tape relative to the deposition zone. The deposition zone is basically stationary. At the same time, the source reservoir and the target reservoir also rotate about the same rotation axis, so a continuous feeding of the tape through the guide structure is possible without fatal twisting of the tape. This feeding can, in general, be done at a speed independent of the speed of rotation about the rotation axis, in particular in a way mechanically gentle to the tape.

In the most simple case, the source reservoir, the guide structure and the target reservoir rotate fully synchronically about the rotation axis (with the same speed). However note that the rotation of the source reservoir and/or the target reservoir and/or the guide structure about the rotation axis may be overlaid by winding the tape off or up. So for example if the winding axes of the source reservoir and the target reservoir are coaxial with the rotation axis, the respective speed of rotation about the rotation axis of the source reservoir, the guide structure and the target reservoir may be different from each other.

By rotating the guide structure or the tape, respectively, relative to the deposition zone, it is also possible to maintain a desired tape temperature at a high precision. In particular, a "quasi-equilibrium" tape heating may be established, typically using a tubular heater configuration.

In the inventive method, there are in general two movements of the tape: A rotational movement around the rotation axis, basically to establish the desired tape speed with respect to the deposition zone, and a "linear" (or feeding) movement, in general substantially parallel to the rotation axis, basically to do the rewinding of the tape. Note that in general, the tape coating of the HTS material can be done in the course of a single rewinding.

### Preferred variants of the inventive method

In a preferred variant of the inventive method, the tape is led by the guide structure in a plurality of elongated windings, with the long sides of the elongated windings extending basically in parallel with the rotation axis. By means of the plurality of windings, a corresponding plurality of tape sections can be presented to the deposition zone by means of rotation of the guide structure in quick succession. This allows a particularly fast and thermally uniform deposition process. The basically parallel orientation allows a simple construction, in particular with few twist of tape. Typically, an angle between the long sides and the direction of the rotation axis is 15° or less, typically 10° or less.

A preferred further development of this variant provides that for at least one long side of each elongated winding, a normal of a flat front side of the tape is oriented radially outward with respect to the rotation axis,
and that over the entirety of the elongated windings, the tape is led circumferentially around the rotation axis, in particular once. In other words, over the entirety of the elongated windings, the tape circumferentially surrounds the rotation axis. This makes efficient use of the available space. The flat front side (which is to be coated, also called the interface side) is well accessible by the deposition process.

In a particularly preferred further development, the elongated windings are mutually interpenetrated, and for both long sides of each elongated winding, the normal of the flat front side of the tape is oriented radially outward with respect to the rotation axis. Here the tape can be accessed at two locations per rotation at each elongated winding, using the available space very efficiently with a minimum of deflections necessary. Note that the rotation axis extends basically at the center of the elongated windings here.

In another further development, the source reservoir, the guide structure and the target reservoir rotate synchronically about the rotation axis during deposition, in particular wherein a winding axis of the source reservoir and a winding axis of the target reservoir are oriented perpendicular to the rotation axis. This is particularly simple, with the rotation and the rewinding being completely independent from each other. If the winding axes are perpendicular to the rotation axis, twisting of the tape may be reduced to a minimum, in particular if elongated windings basically parallel to the rotation axis are used. It is also possible to have the winding axes of the source reservoir and the target reservoir oriented with the same angle with respect to the rotation axis. In particular, the source reservoir and the target reservoir may also be oriented in parallel and coaxial with the rotation axis. This has other advantages in case of a very long tape, e.g. volume and length (in axial direction) of side parts of a processing vacuum chamber may be significantly smaller.

Another preferred variant provides that the guide structure comprises a tubular system on which the tape is wound up and wound off during deposition, said tubular system moving along the rotation axis during deposition caused by the winding of the tape, and that during deposition, the tubular system is rotated about the rotation axis in addition to the rotation caused by winding of the tape. This variant allows a support of the tape on the tubular system during deposition, allowing good control over the tape orientation even at high rotation speeds. Note that in general, the linear speed of tape relative to the cylinder (tubular system) is smaller than the rotational speed. The tubular system typically has a circular outer cross-section.

In a preferred further development of this variant, the tubular system comprises several tubular elements which are successively inserted into and ejected from the guide structure during deposition. This allows the handling of a practically endless tape length. Note that the tubular elements act as intermediate rollers (or roller elements) for the tape.

Another further development provides that a winding axis of the source reservoir and a winding axis of the target reservoir are coaxial with the rotation axis, and that the source reservoir, the target reservoir and the guiding structure are rotated about the common rotation axis with a common basic speed, overlain by specific extra speeds caused by the winding of the tape. This allows a simplified mounting of the source reservoir and target reservoir.

In a preferred variant, during deposition, the speed of rotation of the guide structure is between 1 turns per second and 8 turns per second. This has shown good results in practice for typical guide structure dimensions. At such speeds, bulging of the tape is not yet relevant.

Further preferred is a variant wherein during deposition, the circumferential speed of the tape rotating along with the guide structure is between 0.3 m/s and 2.0 m/s. This is fast enough to improve the quality of the HTS coating in PLD, but bulging of the tape is not yet relevant. Note that for guide structures with low diameter (such as 5 cm or less), also higher circumferential speeds such as up to 4 m/s may be acceptable.

In an advantageous variant, during deposition, the tape is transported from the source reservoir to the target reservoir with a linear speed between 3 m/h (approx. 8.3 *10⁻⁴ m/s) and 200 m/h (approx. 5.6 *10⁻² m/s). This is both mechanically gentle and allows a useful coating progress. Note that for particularly high numbers of windings of tape on the guide structure accessible via a rotation by the deposition zone, such as 12 or more windings, the linear speed may be even higher, such as up to 300 m/h (approx. 8.3*10⁻² m/s).

Further preferred is a variant wherein the tape is transported from the source reservoir to the target reservoir under a tension of between 5 N/mm² and 120 N/mm². By means of the tension, improved control over the tape orientation during deposition may be achieved. In particular, bulging may be reduced.

### Apparatus for depositing HTS on a tape

Also within the scope of the present invention is an apparatus for depositing a high temperature superconductor (=HTS) onto a tape, in particular for use in an inventive method as described above, comprising
a) a source reservoir for the tape, in particular a source coil,
b) a deposition device for providing HTS material on the tape in a deposition zone,
c) a guide structure for leading the tape through the deposition zone,
d) a target reservoir for the tape, in particular a target coil,
e) a drive system, capable of winding the tape off the source reservoir, transporting the tape through the deposition zone and winding up the tape at the target reservoir, in particular by means of a first drive,
f) a heating device for heating the tape transported through the deposition zone,
characterized in that the source reservoir, the guide structure and the target reservoir are mounted rotatably about a common rotation axis,
and that the drive system is further capable of rotating the source reservoir, the guide structure and the target reservoir about the common rotation axis, in particular by means of a second drive. By means of the inventive apparatus, it is possible to store the tape in source and target reservoirs, allowing long tape lengths to be processed by rewinding, and at the same time allow high relative speeds of the tape with respect to a deposition zone (and e.g. a corresponding PLD equipment) without increasing mechanical load or abrasion by rotation. The drive system comprises at least one motor; for example the drive system may comprise common motor for a first drive (doing the rewinding) and a second drive (doing the superimposed rotation), or it may comprise a plurality of motors.

A preferred embodiment of the inventive apparatus provides that the guide structure comprises an elongated holder extending along the rotation axis, in particular a tube, with a plurality of first deflection means for the tape at a first side of the elongated holder, in particular close to the source reservoir, and a plurality of second deflection means for the tape at a second side of the elongated holder, in particular close to the target reservoir, with the deposition zone being located between said first and second sides,
that subsequent first deflection means are arranged turned against each other about the rotation axis by a fixed offset angle,
that subsequent second deflection means are arranged turned against each other about the rotation axis by the fixed offset angle,
and that the second deflection means are arranged turned about the rotation axis with respect to the first deflection means by half the offset angle. With this embodiment, a plurality of elongated windings of the tape can be mounted compactly, wherein the elongated windings or the corresponding flat front sides of the tape, respectively, can be presented to the deposition zone in quick succession by rotating the elongated holder about the rotation axis. From a first deflection means to a respective next second deflection means, only a small angle (i.e. half an offset angle) of twist is established, what is mechanically gentle to the tape. There are typically at least three elongated windings. The elongated holder may be rotated about the rotation axis by means of the drive system, in particular its second drive.

A further development of the above embodiment is characterized in that the first and second deflection means comprise a roller each, with the roller having a diameter larger than a diameter of the elongated holder and with a roller axis of the roller cutting the rotation axis at a right angle,
and that the first deflection means are arranged in a first axial row on the elongated holder, and the second deflection means are arranged in a second axial row on the elongated holder,
in particular such that pairs of first and second deflection means have identical axial distances each. In this arrangement, the rollers may guide the tape over two opposing sides of the elongated holder, so each elongated winding provides the tape two times to the deposition zone per rotation. The identical axial distances provide for identical relaxation times between coating sequences of the tape upon its "linear" progression (rewinding).

In another preferred further development, the source reservoir and the target reservoir are mounted on the elongated holder, in particular wherein winding axes of the source reservoir and of the target reservoir are perpendicular to the rotation axis. Mounting the source and target reservoir on the elongated holder is particularly simple in construction, and allows a maximum of independency of the rotational movement of the elongated holder on the one hand and the rewinding (linear) movement of the tape on the other hand. With the winding axes of the source and target reservoir being perpendicular to the rotation axis minimizes tape twisting if the elongated windings are basically in parallel with the rotation axis. Note that it is also possible to have the winding axes of the source reservoir and the target reservoir oriented with the same angle with respect to the rotation axis.

Preferred is an embodiment of the inventive apparatus wherein the guide structure comprises a tubular system for winding the tape, mounted slidably along the rotation axis relative to the source reservoir and target reservoir, and comprising several separate tubular elements. In this arrangement, the tubular system may support the tape during rewinding, what improves the control over the tape orientation during the HTS material deposition. The separate tube elements can be expelled and refed in order to allow a practically endless rewinding. Typically, the winding axes of the source reservoir and the target reservoir are coaxial with the rotation axis, and the tubular system or the tube elements, respectively, are moveable through the source reservoir and the target reservoir.

In a preferred embodiment, the apparatus comprises a tensioning mechanism for maintaining a tension in the tape during winding, in particular wherein the tensioning mechanism comprises a sliding clutch with clutch discs coupled via one or a plurality of springs. By means of the tensioning mechanism, bulging of the tape during rotation can be minimized. A sliding clutch is proven in practice and simple in construction.

In another advantageous embodiment, the heating device comprises a tubular heater arranged coaxially with the rotation axis, and the tubular heater comprises a deposition window for accessing the deposition zone by the HTS material provided by the deposition device. The tubular heater allows a uniform, quasi equilibrium heating of the tape. The tubular heater is (at least partially) arranged around the deposition zone.

Further preferred is a further development of the above embodiment wherein the tubular heater is surrounded by a heater screen rotatable about the rotation axis, in particular wherein the heater screen has a helical form. By means of the heater screen, the deposition window can at least partially be shut, improving insulation and thus allowing a more uniform heating of the tape. The heater screen may in particular rotate in opposite direction relative to the guide structure leading the tape. The heater screen may be also described as cylinder or multiwall cylinder with a helical window (slit).

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.
- Fig. 1: shows a schematic, partial cross-sectional side view of an inventive apparatus for depositing a HTS on a tape, in a first embodiment with rollers on an elongated holder;
- Fig. 2: shows a schematic, partial cross-sectional top view of a detail of the apparatus of Fig. 1, including a deposition device and a heating device;
- Fig. 3: shows a schematic perspective view of the heater screen of Fig. 3;
- Fig. 4a: shows a schematic axial projection of first deflection means of the elongated holder of Fig. 1;
- Fig. 4b: shows a schematic axial projection of second deflection means of the elongated holder of Fig. 1;
- Fig. 5: shows a schematic axial view of a deflection system for use in a variant of the apparatus of Fig. 1;
- Fig. 6: shows schematic, perspective view of an inventive apparatus for depositing a HTS on a tape, in a second embodiment with coaxial source and target reservoirs and guide structure;
- Fig. 7: a mechanical coupler for use in an inventive apparatus.

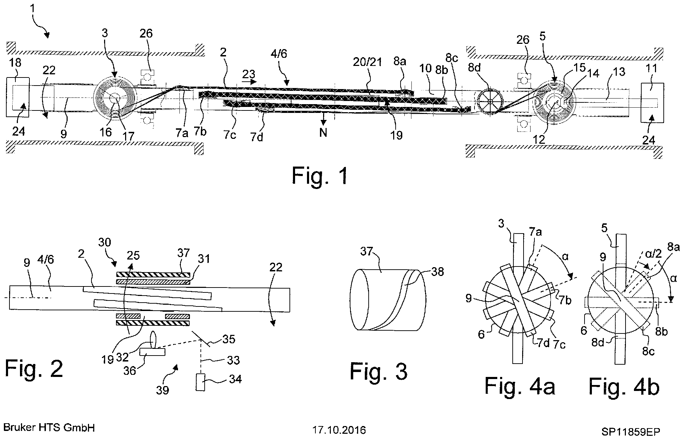

**Fig. 1** shows s first embodiment of an inventive apparatus 1, for performing an inventive method of depositing HTS material on a tape 2.

The tape 2 is wound off a source reservoir 3, here a pancake type source coil, guided via a guide structure 4 to a target coil 5, here a pancake type target coil, where the tape is wound up. The guide structure 4 is formed by an elongated holder 6, which is here generally tube shaped, and which also supports the source and target reservoir 3, 5. The elongated holder 6, including the source reservoir 3, the guide structure 4 and the target reservoir 5, can be rotated about a rotation axis 9; the elongated holder 6 is here supported by ball bearings 26. By this rotation, different parts of the tape 2 are subsequently presented at a deposition zone 21, where HTS material is coated onto the tape 2.

The elongated holder 6 supports here four first deflection means (first deflection devices) 7a-7d, here rollers, in an axial row near the source reservoir 3, and here another four second deflection means (second deflection devices) 8a-8d, here again rollers, in an axial row near the target reservoir 5. The rollers can be rotated about a respective roller axis (see e.g. roller axis 10 at second deflection means 8b), which is perpendicular to the rotation axis 9 and cuts the rotation axis 9. Further, the rollers have a diameter slightly larger than the elongated holder 6 here, so they protrude beyond the elongated holder 6 on two sides (see e.g. at second deflection means 8d, at the top and at the bottom). Therefore, the rollers or deflection means 7b-7d and 8a-8c, respectively, can be used to give the tape 2 an approx. 180° turn, and the tape 2 can be led over the surface of the elongated holder 6 on two opposing sides.

In more detail, the tape 2 is led from the source reservoir 3 to the first deflection means 7a, then led to second deflection means 8a, then (covered in Fig. 1, on the backside of the guide structure 4) led to first deflection means 7b, then led to second deflection means 8b, then (covered in Fig. 1 again) led to first deflection means 7c, then led to the second deflection means 8c, then (covered in Fig. 1 again) led to first deflection means 7d, and then led to second deflection means 8d, and finally led to the target reservoir 5. Accordingly, the tape 2 on the guide structure 4 is led in here 3½ elongated windings by means of the deflection means 7a-7d, 8a-8d, with the elongated windings being (with their long sides) basically in parallel with the rotation axis 9. The tape 2 is presented with flat front sides 19 radially outward with respect to the rotation axis 9 in the area of the elongated windings, compare e.g. normal N on the flat front side 19 of the lowest tape section on the guide structure 4. Subsequent first and second deflection means 7a-7d, 8a-8d, i.e. the pairs 7a/8a, 7b/8b, 7c/8c and 7d/8d, have an equal axial distance along the rotation axis 9.

The first deflection means 7a-7d are twisted with respect to a respective next first deflection means 7a-7d in the sequence of tape guiding by an offset angle α of here 45°, see also the axial view **Fig. 4a****.** Correspondingly, the second deflection means 8a-8d are twisted with respect to a respective next second deflection means in the sequence of tape guiding by the same offset angle α of here 45°, see also **Fig. 4b****.** However, the subsequent first and second deflection means 7a-7d, 8a-8d in the sequence, e.g. the first deflection means 7a and the second deflection means 8a, are twisted with respect to each other by half the offset angle α/2, i.e. 22,5° here. From Figs. 4a, 4b (and Fig. 1) it can be seen that the elongated windings of the tape interpenetrate each other. Over all elongated windings, the rotation axis 9 is surrounded here exactly once. Generally speaking, the course of the tape 2 resembles a polar helix with axially displaced return loops.

Turing to Fig. 1 again, the apparatus 1 comprises a first drive 11, which drives the target reservoir 5 which is held in the elongated holder 6. The target reservoir 5 has a winding axis 12 perpendicular to the rotation axis 9, and is here coupled to the first drive 11 via a shaft 13 and bevel wheels 14, 15. By pulling slowly pulling via the target reservoir 5, tape 2 can be wound off the source reservoir 3 (which can rotate about a winding axis 17 perpendicular to the rotation axis 9) and fed through the guide structure 4 or its deflection means 7a-7d, 8a-8d, respectively. This causes a "linear" (or feeding) movement 23 of the tape 2. At the source reservoir 3, there is installed a tensioning mechanism 16, here a sliding clutch/mechanical coupler coupling the source reservoir 3 and the elongated holder 6, which keeps the tape 2 at a minimum tension needed to compensate for a centrifugal force caused by rotation about the rotation axis 9. The sliding clutch comprises sliding discs coupled via one or a plurality of springs, and only when the tension is above a limit value, a rotation corresponding to a tooth's progress is released, with the tension not being fully released, but kept at a minimum value, as set by said spring(s) (not shown in Fig. 1).

Further, a second drive 18 is provided by means of which the entire elongated holder 4, including the source reservoir 3, the guide structure 4 and the target reservoir 5, can be rotated about the rotation axis 9. By rotating the guide structure 4 together with the tape 2, the elongated windings of the tape 2 or its outwardly presented flat sides 19 (compare e.g. radially outward directed normal N at the lowest tape section) pass subsequently a deposition window 20 defining the deposition zone 21 of the apparatus 1. Accordingly, the tape 2 undergoes a rotational movement 22. While the "linear" movement 23 is typically rather slow, such as about 10⁻³ m/s, the rotational movement 22 is rather fast, such as 1 m/s at the tape surface.

The first drive 11 and the second drive 18 are part of a drive system 24 of the apparatus 1, here comprising separate motors at the first and second drive 11, 18. Note that alternatively, both drives 11, 18 may use a common motor, with the elongated holder 6 and the target reservoir 5 being driven via different coupling and gear systems. Further note that it is also possible to drive both the source and target reservoir 3, 5 directly.

**Fig. 2** illustrates the deposition process, here based on PLD (pulsed laser deposition) in some more detail.

The tape 2 guided on the guide structure 4 or elongated holder 6, respectively, is heated by a heating device 30, here comprising a tubular heater 31. The tubular heater 31 brings the tape 2 in its interior to a temperature of about 500°C or even more. The tubular heater 31 exhibits the deposition window 19, i.e. an opening through which plasma type HTS material 32 can pass. The plasma type HTS material 32 is generated by a laser beam 33 generated by a laser 34, and here directed by means of a rotatable mirror 35 onto a target 36, basically made of the HTS material to be deposited. The laser 34, the rotatable mirror 35 and the target 36 form a deposition device 39 here. It should be noted that at least the target 36 and the tape 2 on the guide structure 4 are located in an evacuated deposition chamber, and often practically the whole apparatus 1 (see Fig. 1) is under vacuum conditions (note that laser 34 may well be located under normal pressure, with the laser beam 33 being led by a glass fiber into the deposition chamber, though).

The heating device 30 here also comprises a heater screen 37, also of generally tubular shape, which can be rotated about the rotation axis 9 by a motor (not shown), compare rotational movement 25.

The heater screen 37 possesses a helical slit 38, see Fig. 3, through which the HTS material 32 may pass. The heater screen 37 reduces loss of heat from the tubular heater 31 and through the deposition window 19, and thus makes the heat distribution inside more uniform, improving the quality of a HTS coating on the tape 2.

The pulses of the laser beam 33 (including their position on the target 36, controlled by the position of the rotatable mirror 35) and the rotational position of the slit 38 are synchronized in order to achieve a desired coating of the tape 2. Note that preferably, the rotation movement 22 of the guide structure 4 and the rotation movement 25 of the heater screen are opposite to each other.

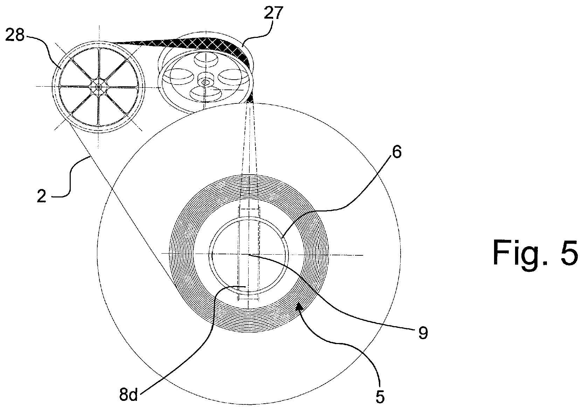

In Fig. 1, the winding axes 17, 12 of the source and target reservoir 3, 5 are perpendicular to the rotation axis 9, and oriented in parallel or close to the orientation of the roller axes of the closest deflection means 7a, 8d. However, it is also possible to support the source and target reservoirs 3, 5 in other orientations on the elongated holder 6. For example, the winding axes 17, 12 may be coaxial with the rotation axis 9. In this case, however, the tape 2 has to be deflected, for example as shown in **Fig. 5** (showing a view along rotation axis 9). There, two auxiliary deflection rollers 27, 28 are used to lead the tape 2 here from the last second deflection means 8d to the target reservoir 5. The auxiliary deflection rollers 27, 28 are rigidly mounted at the elongated holder 6.

Note that a typical diameter of the elongated holder 6 is between 50 mm and 120 mm. The length of the elongated holder 6 is typically between 80 cm and 200 cm, preferably between 100 cm and 160 cm. The tape 2 typically has a thin metal substrate, such as a stainless steel substrate, and a typical HTS coating is YBCO. Typical tape widths are typically between 4 mm and 25 mm, preferably between 8 mm and 15 mm. Typical tape lengths processed with the invention are 40 m or more, preferably 100 m or more.

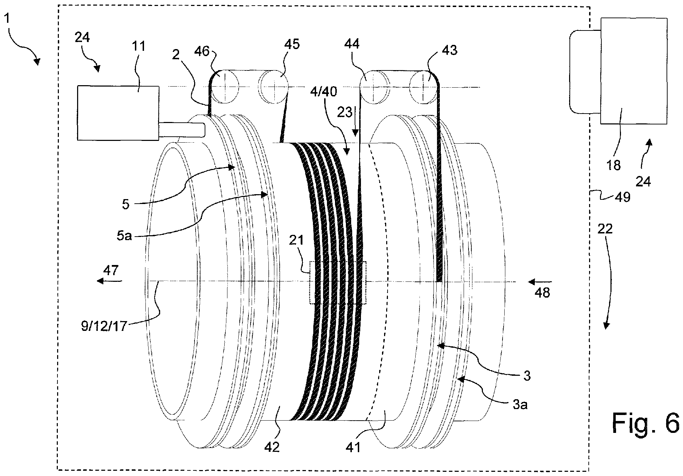

**Fig. 6** shows another embodiment of an inventive apparatus 1 for coating a tape 2 with HTS material, comprising a source reservoir 3, here a pancake type source coil, a guide structure 4 formed by a tubular system 40 on which the tape 2 is wound, and a target reservoir 5, here again a pancake type target coil. The tubular system 40 comprises several tubular elements 41, 42, two of which are shown in Fig. 6. Further, there are auxiliary deflection rollers 43-46 for the tape 2. The source reservoir 3 and the target reservoir 5 for the tape to be coated are mounted rotatably here on the tubular system 40 (e.g. by ball bearings, not shown) about a common rotation axis 9, and the tubular system 40, too, is mounted rotatably about the rotation axis 9. In other words, the winding axes 17, 12 of the source and target reservoir 3, 5 are coaxial with the rotation axis 9. In the embodiment shown, there are also source and target auxiliary reservoirs 3a, 5a for a support tape (not shown) to be wound together with the tape 2, if desired, which may be handled together with the respective source or target reservoir 3, 5.

In the embodiment shown, a first drive 11 of a drive system 24 drives the target reservoir 5 (the coupling details not being shown, for simplification), thus winding up tape 2 on the target reservoir 5. By pulling on the tape 2, tape 2 is wound off the tubular system 40 on the left side of Fig. 6, and tape 2 is wound up on the right side of the tubular system 40. Further, tape 2 is wound off the source reservoir 2; a tensioning mechanism (not shown) can act e.g. on the source reservoir 3, if desired. Note that depending on the amount of tape 2 already wound, the source reservoir 3, the tubular system 40 and the target reservoir 5 may exhibit somewhat different rotation speeds due to the rewinding process.

By the winding of the tape 2 on the tubular system 40, the tubular element 42 is propelled along the rotation axis 9 to the left in Fig. 6. In order to have sufficient area of support upon further rewinding of the tape 2, the next tubular element 41 is moved in keeping with the previous tubular element 42 along the rotation axis 9. Note that tubular elements will be expelled on the left, see arrow 47, and further tubular elements have to be inserted on the right side, see arrow 48, from time to time. The speed of the "linear" movement 23 of the tape 2 by the rewinding process is relatively slow, such as about 10⁻³ m/s.

In order to provide a higher relative speed of the tape 2 at a deposition zone 21, in the embodiment shown, the entirety 49 of the source reservoir 3, the guide structure 4 and the target reservoir 5 can be rotated about the rotation axis 9 and relative to the deposition zone 21 by means of a second drive 18 of the drive system 24 (the coupling details again not being shown, for simplification). A basic rotation movement 22 of the entirety 49 about the rotation axis 9 is typically on the order of 1 m/s at the tape surface. Note that in general, a constant relative speed of the tape 2 with respect to the deposition zone 21 is used for deposition. Further note that the contribution of the "linear" movement 23 is generally negligible as compared to the contribution of the rotation movement 22.

Alternatively, the drive system 24 may provide for separate but synchronized driving and rotation of the source reservoir 3, the auxiliary deflection rollers 43, 44, the tubular system 40, the auxiliary deflection rollers 45, 46, and/or the target reservoir 5 (not shown in detail). Then the drive system 24 may be based on well-synchronized (but not necessarily with identical rotation speeds) drives and/or mechanical differentials. To provide such a helical tape winder that is capable of continuous rotation, the tubular system 40 should be capable of axial motion. This axial motion has to be continuous and synchronized with the speed of the tape winding.

A typical diameter of the tubular system 40 is between 20 cm and 180 cm. Typical axial lengths of tubular elements 41, 42 are between 30 cm and 150 cm. For typical tapes and coatings see above.

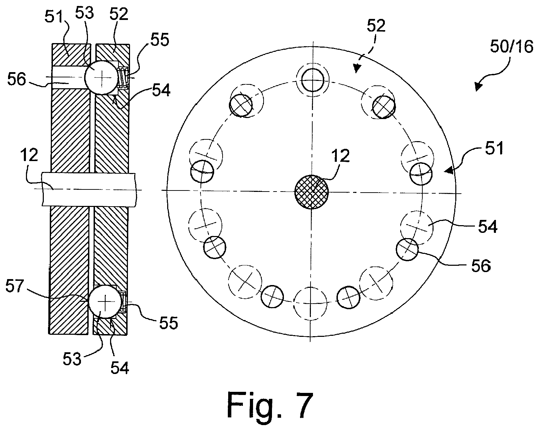

Fig. 7 illustrates a sliding clutch/mechanical coupler 50 for use with the present invention, as a tensioning mechanism 16 (see e.g. in Fig. 1).

A tensioning mechanism in accordance with the invention may be based on a simple friction between two discs. Preferably, though, the tensioning mechanism is based on the power of springs.

In the embodiment shown in Fig. 7 (with a cross section along the winding axis 12 on the left, and a half transparent cross-section perpendicular to the winding axis 12 on the right), the sliding clutch/coupling mechanism 50 comprises two discs 51, 52, one of which is fixed at the elongated holder and one of which is rotatable about the winding axis 12. The rotatable disc is attached to the source reservoir (not shown). The discs 51, 52 have a fixed axial distance with respect to each other. Disc 52 houses a plurality of metallic balls 53 in housings 54, wherein the metallic balls 53 are pretensioned towards an extended position by springs 55. Disc 51 comprises a plurality of openings 56, into which the metallic balls 53 may penetrate when a respective housing 54 lies opposite to the opening 56 (see left cross-section, top). If a housing 54 lies opposite to a flat, closed part 57 of disc 51, the metallic ball 53 is pushed back against the force of the spring 55 (see left cross-section, bottom).

As a consequence, discs 51, 52 may lock in a plurality of relative rotational positions, depending on the number of housings 54 and the number of openings 56 distributed in the discs 52, 51. In the example shown, disc 51 comprises nine openings 56, and disc 52 comprises ten housings 54. When pulling strong enough on the tape wound on the source reservoir which is connected to the rotatable disc, the disc may switch from its locked position to a next one, whereupon some of the pulling tension is released. The remaining pulling tension, which is not strong enough to cause another switching of the locked position, may keep the tape straight.

So in summary, the sliding clutch/coupling mechanics 50 shown is based on an elastic force created by a multitude of metallic balls 53 in one disc 52, one of which enters (at least partly) into one of a plurality of openings 56 foreseen in the opposite disc 51.

The invention may be used to manufacture superconducting tapes and wires, in particular HTS coated conductors. More specifically, the invention may be used in manufacturing of cables, particularly Roebel cables, diamagnetic screens, fault current limiters, superconducting spools, windings, motor/generator coils, magnets, transformers cables and current leads.

### List of reference signs

- 1: apparatus
- 2: tape
- 3: source reservoir
- 3a: source auxiliary reservoir
- 4: guide structure
- 5: target reservoir
- 5a: target auxiliary reservoir
- 6: elongated holder
- 7a-7d: first deflection means
- 8a-8d: second deflection means
- 9: rotation axis
- 10: roller axis
- 11: first drive
- 12: winding axis
- 13: shaft
- 14, 15: bevel wheels
- 16: tensioning mechanism
- 17: winding axis
- 18: second drive
- 19: flat front side
- 20: deposition window
- 21: deposition zone
- 22: rotation movement (guide structure)
- 23: linear (feeding) movement
- 24: drive system
- 25: rotation movement (heater screen)
- 26: ball bearing
- 27, 28: auxiliary deflection rollers
- 30: heating device
- 31: tubular heater
- 32: (plasma type) HTS material
- 33: laser beam
- 34: laser
- 35: rotatable mirror
- 36: target
- 37: heater screen
- 38: helical slit
- 39: deposition device
- 40: tubular system
- 41, 42: tubular elements
- 43-46: auxiliary deflection roller
- 47: arrow (direction of expelling tubular element)
- 48: arrow (direction of inserting tubular element)
- 49: entirety
- 50: sliding clutch/mechanical coupler
- 51, 52: discs
- 53: metallic ball
- 54: housing
- 55: spring
- 56: opening
- 57: flat, closed part
- α: offset angle

## Claims

1. Method for depositing a high temperature superconductor (=HTS) onto a tape (2), in particular by pulsed laser deposition (=PLD),
wherein the tape (2) is wound off a source reservoir (3), heated and transported through a deposition zone (21), and wound up at a target reservoir (5),
wherein HTS material (32) is deposited onto the heated transported tape (2) in the deposition zone (21),
and wherein the tape (2) is led through the deposition zone (21) by means of a guide structure (4);
**characterized in**
**that** during deposition of the HTS material (32), the source reservoir (3), the guide structure (4) and the target reservoir (5) are rotated around a common rotation axis (9), such that parts of the tape (2) rotating along with the guide structure (4) repeatedly cross the deposition zone (21).

2. Method according to claim 1, **characterized in that** the tape (2) is led by the guide structure (4) in a plurality of elongated windings, with the long sides of the elongated windings extending basically in parallel with the rotation axis (9).

3. Method according to claim 2, **characterized in that** for at least one long side of each elongated winding, a normal (N) of a flat front side (19) of the tape (2) is oriented radially outward with respect to the rotation axis (9),
and that over the entirety of the elongated windings, the tape (2) is led circumferentially around the rotation axis (9), in particular once.

4. Method according to claim 2 or 3, **characterized in that** the elongated windings are mutually interpenetrated, and that for both long sides of each elongated winding, the normal (N) of the flat front side (19) of the tape (2) is oriented radially outward with respect to the rotation axis (9).

5. Method according to one of the claims 2 through 4, **characterized in that** the source reservoir (3), the guide structure (4) and the target reservoir (5) rotate synchronically about the rotation axis (9) during deposition, in particular wherein a winding axis (17) of the source reservoir (3) and a winding axis (12) of the target reservoir (5) are oriented perpendicular to the rotation axis (9).

6. Method according to claim 1, **characterized in**
**that** the guide structure (4) comprises a tubular system (40) on which the tape (2) is wound up and wound off during deposition, said tubular system (40) moving along the rotation axis (9) during deposition caused by the winding of the tape (2),
and **that** during deposition, the tubular system (40) is rotated about the rotation axis (9) in addition to the rotation caused by winding of the tape (2).

7. Method according to claim 6, **characterized in that** the tubular system (40) comprises several tubular elements (41, 42) which are successively inserted into and ejected from the guide structure (4) during deposition.

8. Method according to claim 6 or 7, **characterized in that** a winding axis (17) of the source reservoir (3) and a winding axis (12) of the target reservoir (5) are coaxial with the rotation axis (9),
and that the source reservoir (3), the target reservoir (5) and the guiding structure (4) are rotated about the common rotation axis (9) with a common basic speed, overlain by specific extra speeds caused by the winding of the tape (2).

9. Method according to one of the preceding claims, **characterized in that** during deposition, the speed of rotation of the guide structure (4) is between 1 turns per second and 8 turns per second.

10. Method according to one of the preceding claims, **characterized in that** during deposition, the circumferential speed of the tape (2) rotating along with the guide structure (4) is between 0.3 m/s and 2.0 m/s.

11. Method according to one of the preceding claims, **characterized in that** during deposition, the tape (2) is transported from the source reservoir (3) to the target reservoir (5) with a linear speed between 3 m/h (approx. 8.3 *10⁻⁴ m/s) and 200 m/h (approx. 5.6 *10⁻² m/s).

12. Method according to one of the preceding claims, **characterized in that** the tape (2) is transported from the source reservoir (3) to the target reservoir (5) under a tension of between 5 N/mm² and 120 N/mm².

13. An apparatus (1) for depositing a high temperature superconductor (=HTS) onto a tape (2), in particular for use in a method according to one of the preceding claims, comprising
a) a source reservoir (3) for the tape (2), in particular a source coil,
b) a deposition device (39) for providing HTS material (32) on the tape (2) in a deposition zone (21),
c) a guide structure (4) for leading the tape (2) through the deposition zone (21),
d) a target reservoir (5) for the tape (2), in particular a target coil,
e) a drive system (24), capable of winding the tape (2) off the source reservoir (3), transporting the tape (2) through the deposition zone (21) and winding up the tape (2) at the target reservoir (5), in particular by means of a first drive (11),
f) a heating device (30) for heating the tape (2) transported through the deposition zone (21),
**characterized in**
**that** the source reservoir (3), the guide structure (4) and the target reservoir (5) are mounted rotatably about a common rotation axis (9), and that the drive system (24) is further capable of rotating the source reservoir (3), the guide structure (4) and the target reservoir (5) about the common rotation axis (9), in particular by means of a second drive (18).

14. Apparatus (1) according to claim 13, **characterized in that** the guide structure (4) comprises an elongated holder (6) extending along the rotation axis (9), in particular a tube, with a plurality of first deflection means (7a-7d) for the tape (2) at a first side of the elongated holder (6), in particular close to the source reservoir (3), and a plurality of second deflection means (8a-8d) for the tape (2) at a second side of the elongated holder (6), in particular close to the target reservoir (5), with the deposition zone (21) being located between said first and second sides,
that subsequent first deflection means (7a-7d) are arranged turned against each other about the rotation axis (9) by a fixed offset angle (α), that subsequent second deflection means (8a-8d) are arranged turned against each other about the rotation axis (9) by the fixed offset angle (α),
and that the second deflection means (8a-8d) are arranged turned about the rotation axis (9) with respect to the first deflection means (7a-7d) by half the offset angle (α/2).

15. Apparatus (1) according to claim 14, **characterized in**
**that** the first and second deflection means (7a-7d, 8a-8d) comprise a roller each, with the roller having a diameter larger than a diameter of the elongated holder (6) and with a roller axis (10) of the roller cutting the rotation axis (9) at a right angle,
and **that** the first deflection means (7a-7d) are arranged in a first axial row on the elongated holder (6), and the second deflection means (8a-8d) are arranged in a second axial row on the elongated holder (6),
in particular such that pairs (7a/8a, 7b/8b, 7c/8c, 7d/8d) of first and second deflection means (7a-7d, 8a-8d) have identical axial distances each.

16. Apparatus (1) according to claim 14 or 15, **characterized in that** the source reservoir (3) and the target reservoir (5) are mounted on the elongated holder (6), in particular wherein winding axes (17, 12) of the source reservoir (3) and of the target reservoir (5) are perpendicular to the rotation axis (9).

17. Apparatus (1) according to claim 13, **characterized in that** the guide structure (4) comprises a tubular system (40) for winding the tape (2), mounted slidably along the rotation axis (9) relative to the source reservoir (3) and target reservoir (9), and comprising several separate tubular elements (41, 42).

18. Apparatus (1) according to one of the claims 13 through 17, **characterized in that** the apparatus (1) comprises a tensioning mechanism (16) for maintaining a tension in the tape (2) during winding, in particular wherein the tensioning mechanism (16) comprises a sliding clutch (50) with clutch discs (51, 52) coupled via one or a plurality of springs (55).

19. Apparatus (1) according to one of the claims 13 through 18, **characterized in that** the heating device (30) comprises a tubular heater (31) arranged coaxially with the rotation axis (9), and that the tubular heater (31) comprises a deposition window (20) for accessing the deposition zone (21) by the HTS material (32) provided by the deposition device (39).

20. Apparatus (1) according to claim 19, **characterized in that** the tubular heater (31) is surrounded by a heater screen (37) rotatable about the rotation axis (9), in particular wherein the heater screen (37) has a helical form.
